(19) Europäisches Patentamt
European Patent Office
Office européen des brevets

(11) **EP 2 531 572 B1**

(12) **EUROPEAN PATENT SPECIFICATION**

(45) Date of publication and mention
of the grant of the patent:
**16.09.2015  Bulletin 2015/38**

(21) Application number: **11705696.0**

(22) Date of filing: **27.01.2011**

(51) Int Cl.:
*C09K 11/59* (2006.01)      *C04B 35/581* (2006.01)
*H01L 33/50* (2010.01)      *C04B 35/584* (2006.01)

(86) International application number:
**PCT/IB2011/050362**

(87) International publication number:
**WO 2011/095915 (11.08.2011 Gazette 2011/32)**

(54) **PHOSPHOR CONVERTED LED**

PHOSPHORKONVERTIERTE LED

DEL À CONVERSION PAR UN LUMINOPHORE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.02.2010  EP 10152489**

(43) Date of publication of application:
**12.12.2012  Bulletin 2012/50**

(73) Proprietors:
 • **Koninklijke Philips N.V.
   5656 AE Eindhoven (NL)**
   Designated Contracting States:
   **AL AT BE BG CH CY CZ DK EE ES FI FR GB GR
   HR HU IE IS IT LI LT LU LV MC MK MT NL NO PL
   PT RO RS SE SI SK SM TR**
 • **Philips Intellectual Property & Standards GmbH
   20099 Hamburg (DE)**
   Designated Contracting States:
   **DE**

(72) Inventors:
 • **SCHMIDT, Peter, Josef
   NL-5656 AE Eindhoven (NL)**
 • **BECHTEL, Hans-Helmut
   NL-5656 AE Eindhoven (NL)**

(74) Representative: **Rüber, Bernhard Jakob
   Lumileds Germany GmbH
   Intellectual Property
   Philipsstraße 8
   52068 Aachen (DE)**

(56) References cited:
   **WO-A1-03/080763       WO-A1-2007/052200
   WO-A2-2008/007232     US-A1- 2006 255 710
   US-A1- 2008 116 467**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention is directed to novel light emitting device comprising a stack of luminescent layers, especially a pcLED comprising a combination of a green emitting luminescent ceramic material and an orange emitting luminescent layer.

BACKGROUND OF THE INVENTION

Phosphors comprising silicates, phosphates (for example, apatite) and aluminates as host materials, with transition metals or rare earth metals added as activating materials to the host materials, are widely known. As blue LEDs, in particular, have become practical in recent years, the development of white light sources utilizing such blue LEDs in combination with such phosphor materials is being energetically pursued.

Today's warm white phosphor converted LEDs (pcLEDs) are produced e.g. by combining a YAG phosphor with a red phosphor powder layer. Variations in phosphor layer thickness currently lead to variation of the white LED color point away from the Planckian locus, which in general is an aim. An advantage of layered phosphor combinations compared to a powder mixture of two phosphor layers is a reduced interaction of the phosphors, i.e. absorption of emitted light of the green phosphor by the red emitting phosphor. Due to variations in the red phosphor layer thickness the resulting change of color moves away from the Planckian locus and the resulting emission color is no longer white.

Different color emitting luminescent materials have been in the focus of interest and several materials have been proposed, e.g. in the Journal of Materials Science, 2009, V 44, p 4763 - 4775.

However, there is still the continuing need for warm white phosphor converted LEDs having an optimized luminous efficiency and color rendering which are usable within a wide range of applications.

WO 2007/052200 A1 discloses a light emitting device with a light source to emit primary light and a light conversion layer to convert at least a part of the primary light into secondary light comprising a CaAlSiN light converting material with a transmissivity of > 10% to ≤ 80% for a light in the wavelength range from >580 to ≤ 1000nm.

WO 2008/0116467 A1 discloses a ceramic body comprising a wavelength converting material being disposed in the path of light emitted by a light emitting region of a semiconductor structure comprising a light emitting region disposed between an n-type region and a p-type region. A layer of transparent material is also disposed in the path of light emitted by the light emitting region. The transparent material may connect the ceramic body to the semiconductor structure. Particles configured to scatter light emitted by the light emitting region are disposed in the layer of adhesive material. In some embodiments the particles are phosphor; in some embodiments the particles are not a wavelength-converting material.

WO 03/080763 A1 relates to a tri-color lamp for generating white light comprising a phosphor composition comprising a phosphor of general formula $(Ba_{1-x-y-z-} Sr_x Ca_y)_2 SiO_4 : Eu_z$, wherein $0 <= x <= 1$, $0 <= y <= 1$ and $0 < z < 1$. The phosphor composition may also comprise a red phosphor. The two phosphors can absorb radiation emitted by a light emitting diode, particularly a blue LED. This arrangement provides a mixing of three light sources -light emitted from the two phosphors and unabsorbed light from the LED. The invention also relates to an alternative to a green LED comprising a single green phosphor of general formula $(Ba_{1-x-y-z}-Sr_x Ca_y)_2 SiO_4 : Eu_z$, wherein $0 <= x <= 1$, $0 <= y <= 1$ and $0 < z < 1$, that absorbs radiation from a blue LED. A resulting device provides green light of high absorption efficiency and high luminous equivalent values.

WO 2008/007232 A3 discloses a light-emitting device is disclosed, which comprises a radiation source, an inorganic layer comprising a luminescent material; and a scattering layer comprising scattering particles. The scattering layer is located between the radiation source and the inorganic layer, which is composed of a ceramic material.

US2006/0255710A1 discloses an illumination system with an LED and two phosphor materials. A first phosphor comprises a green phosphor and a second phosphor comprises a CaAlSiN3:Ce, Eu (2 %, 0.1 %) phosphor.

SUMMARY OF THE INVENTION

It is an object of the present invention to provide a warm white pcLED with optimized luminous efficiency and color rendering.

This object is solved by a light emitting device according to claim 1 of the present invention. Accordingly, a light emitting device is provided, comprising a blue emitting LED, a first phosphor layer exited at the emitting wavelength of the LED, which ceramic phosphor has an emission wavelength within a range of between 500 nm and 560 nm, and a second phosphor layer having a color point u' in the range between 0.24 and 0.35 and a peak emission of the phosphor layer of λp > 600nm.

It should be understood that u' is defined by the definitions of the uniform color space CIE 1976. According to CIE 1976 and CIE Standard S 014-5/E:2009 u' is defined as:

$$u' = \frac{4x}{-2x + 12y + 3}$$

According to the invention the phosphor has a color point u' in the range between 0.24 and 0.35 and a peak emission of the phosphor layer of $\lambda p > 600nm$ comprises a material according to the general formula

$$M_{1-x-y-z}Si_{1+z}Al_{1-z}N_{3-z}O_z:Eu^{2+}{}_xCe^{2+}{}_y,$$

whereby
M is selected from the group consisting of Ca, Sr or mixtures thereof; and whereby $0.0001 \leq x \leq 0.005$; $0.001 \leq y \leq 0.05$ and $0.05 \leq z \leq 0.25$.

It should be noted that by the term "$M_{1-x-y-z}Si_{1+z}Al_{1-z}N_{3-z}O_z:Eu^{2+}{}_xCe^{2+}{}_y$" especially and/or additionally any material is meant and/or included, which has essentially this composition.

The term "essentially" means especially that $\geq 95$ %, preferably $\geq 97$ % and most preferred $\geq 99$ % wt-%.

Such a material has shown for a wide range of applications within the present invention to have at least one of the following advantages:

Using the material as luminescent layer, LEDs may be built which show improved lighting features, especially color rendering in warm white phosphor converted LEDs.

The material has been found to have a broad band emission and an appropriate red emission especially suited for white pcLEDs.

The material has been found to be capable to compensate color variations caused by varying layer thickness of red phosphor layers in pcLEDs.

According to a preferred embodiment of the present invention, x is $\geq 0.0002$ and $\leq 0.0005$. This has been found to be advantageous for many applications, since when x is too high, the color point of the material is not in the range to compensate the color variations caused by the varying thickness red phosphor layers in pcLEDs. If x is too low, the color rendering properties deteriorate.

According to a preferred embodiment of the present invention, the luminescent material is a ceramic body. The term "ceramic" in the sense of the present invention means and/or includes especially a crystalline or polycrystalline compact material or composite material with a controlled amount of pores or which is pore free.

According to a preferred embodiment of the present invention, y is $\geq 0.001$ and $\leq 0.04$, preferably $\geq 0.002$ and $\leq 0.005$, and more preferred $\geq 0.02$ and $\leq 0.03$. In the material as defined above Ce is deemed to act as a second emitting material. Ce doping makes the material emitting in a green to orange color range, while Eu doping makes the material emitting in a deep red color range. Surprisingly, doping of the material with both rare-earth elements makes the material emitting in the inventive way.

According to a preferred embodiment of the present invention, z is $\geq 0.1$ and $\leq 0.15$. In general, the oxygen content in the material is deemed to be a result of impurities of the basic material. However, if the contend of oxygen in the material is too high, the red component of the emission will be too low. This makes the material emitting in a yellow range, rather than emitting in the intended color range.

According to a preferred embodiment, the content of Ca in M is $\geq 80$% (mol/mol), more preferred $\geq 90$%.

According to another preferred embodiment, the content of Sr in M is $\geq 80$% (mol/mol), more preferred $\geq 90$%.

The material has a color point u' in a CIE chromaticity diagram in the range of between 0.24 and 0.35. This has been found to be advantageous for many applications, since this color point is appropriate to compensate color variations of red phosphor layers in pcLEDs.

The peak emission of the second phosphor layer $\lambda p$ is $> 600nm$, preferably $\lambda p$ is $> 610$ nm. This has been found to be advantageous for many applications, since it enables an adequate color rendering CRI $> 75$.

According to an embodiment of the invention, the blue emitting LED may have a peak emission wavelength within the range of between 400 nm and 480 nm. This has been found to be advantageous for many applications, since such an emission wavelength excites the ceramic green emitting phosphors as well as the phosphor layer having a color point u' in the range between 0.24 and 0.35 and a peak emission of the phosphor layer of $\lambda p > 600nm$ in a way, that an optimized luminous efficiency and color rendering can be achieved.

According to an embodiment of the invention, the first phosphor layer is a sintered polycrystalline ceramic body. The ceramic body may have a layer thickness within the range of between 80 $\mu$m and 300 $\mu$m. In a preferred embodiment, the first phosphor layer is a ceramic body, like e.g. a lumiramic™.

In a further embodiment according to the invention, the phosphor layer having a color point u' in the range between 0.24 and 0.35 and a peak emission of the phosphor layer of $\lambda p > 600nm$ is a mixture of different phosphor materials, which mixture leads to a phosphor layer having the mentioned properties with respect to the color point and the peak emission wavelength of the emission spectra. In an embodiment, the mixture comprises a first luminescent material of the general formula $Lu_3Al_5O_{12}$:Ce or $SrSi_2O_2N_2$:Eu and a second luminescent material which may be a conventional red phosphor material, like e.g. $CaAlSi(N,O)_3$:Eu, $CaSiN_2$:Eu, $CaSi_5N_8$:Eu, or $Sr_2SiN_2$:Eu.

The present invention furthermore relates to a light emitting material, especially a LED, comprising at least one material as described above.

A light emitting device according to the present invention may be of use in a broad variety of systems and/or applications, amongst them one or more of the following:

> office lighting systems
> household application systems
> shop lighting systems,
> home lighting systems,
> accent lighting systems,
> spot lighting systems,
> theater lighting systems,
> fiber-optics application systems,
> projection systems,
> self-lit display systems,
> pixelated display systems,
> segmented display systems,
> warning sign systems,
> medical lighting application systems,
> indicator sign systems, and
> decorative lighting systems
> portable systems
> automotive applications
> green house lighting systems

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

BRIEF DESCRIPTION OF THE DRAWINGS

Additional details, features, characteristics and advantages of the object of the invention are disclosed in the subclaims, the figures and the following description of the respective figures and examples, which --in an exemplary fashion-- show several embodiments and examples of materials according to the invention.

> Fig. 1 shows CIE 1976 color coordinates of an of a state of the art pcLED comprising a red phosphor and a pcLED comprising a luminescent material according to an embodiment of the invention; and
> Fig. 2 shows CIE 1976 color coordinates with color points for a blue LED, a green luminescent ceramic (lumiramic™) and an orange luminescent material according to an embodiment of the invention; and
> Fig. 3 shows a comparison of an emission spectrum of a luminescent material according to an embodiment of the invention and of a red phosphor according to the state of the art.
> Fig. 4 shows the emission spectra of another embodiment according to the invention.

DETAILED DESCRIPTION OF THE EMBODIMENTS

The invention will be further understood by the figures and the following description.

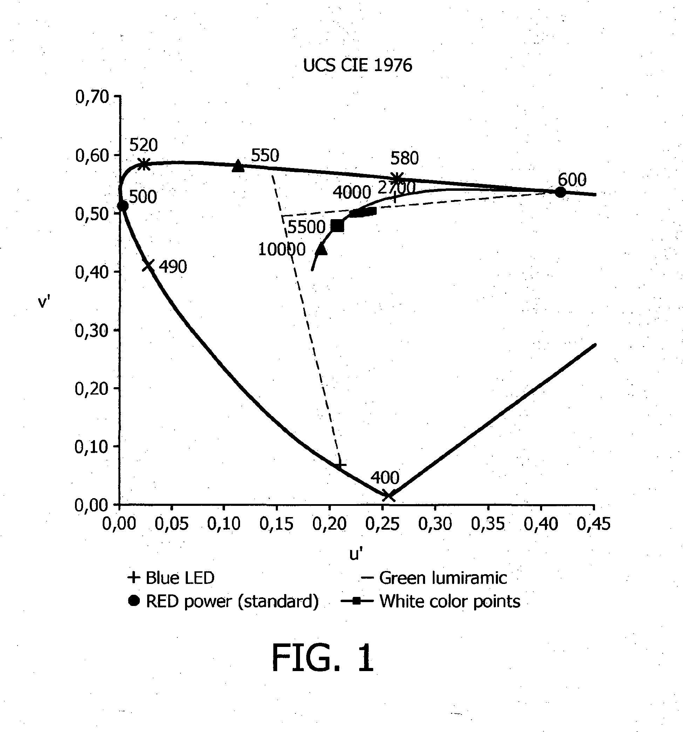

Fig. 1 shows CIE 1976 color coordinates of an of a state of the art pcLED comprising a red phosphor and a pcLED comprising a luminescent material according to an embodiment of the invention having the generic formula $Ca_{1-x-y-z}Si_{1+z}Al_{1-z}N_{3-z}O_z$:$Eu^{2+}_x$$Ce^{2+}_y$, whereby x is 0.004, y is 0.01 and z is 0.06. Fig. 1 represents the variation of the color points of a state of the art combination of a lumiramic with a red phosphor at increasing thickness of the red phosphor layer (thickness increasing from left to right). As it can be seen the color point strongly depends on the layer thickness of the red phosphor layer. On the other hand, the color point of the luminescent material according to the invention is varying almost only along the Planckian with varying thickness of the red/orange phosphor layer. This is due to the broad band emission of the inventive luminescent material, which enables good color rendering CRI >75 for white LEDs.

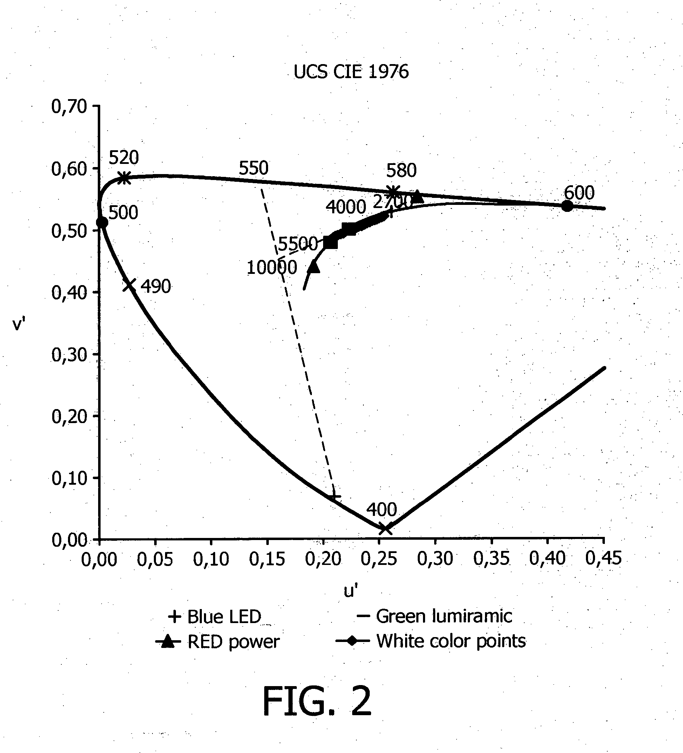

Fig. 2 shows CIE 1976 color coordinates with color points for a blue LED, a green luminescent ceramic (Lumiramic™) and an orange luminescent material according to an embodiment of the invention. In order to realize a red and green phosphor combination with superior layer thickness tolerance for viable production of with LEDs and maintaining good color rendering a luminescent material (orange phosphor) according to the invention is selected and combined in a pcLED-device with an green luminescent ceramic (Lumiramic™). As shown in Fig. 2, the white color points vary along the Planckian with varying thickness of the red /orange phosphor layer. The use of a luminescent material according to the invention therefore makes the production of white pcLEDs on basis of a blue emitting LED much more reliable since the effect of the phosphor layer thickness on the color point is significantly reduced.

Fig, 3 shows an emission spectrum of a luminescent material (CECAS) according to the generic formula $Ca_{1-x-y-z}Si_{1+z}Al_{1-z}N_3O_z:Eu^{2+}{}_xCe^{2+}{}_y$, whereby x is 0.004, y is 0.01 and z is 0.06 for 450 nm excitation with an emission maximum at about 625 nm and an FWHM (full width half maximum) of more than 120 nm. Such a broad emission enables to compensate layer thickness variation of the phosphor layer over a wide range. In comparison the emission spectra of a conventional red phosphor is shown.

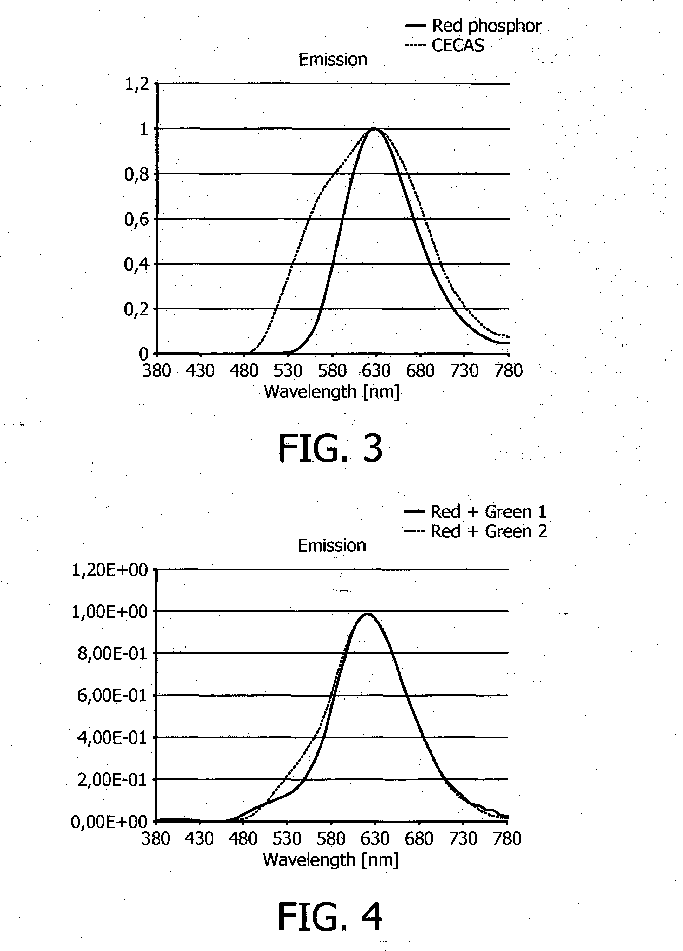

Fig. 4 shows the emission spectra of another embodiment according to the invention. Here, two different green phosphors are mixed with conventional a red phosphor to achieve the desired color point. The first green phosphor is a luminescent material according to the general formula $Lu_3Al_5O_{12}:Ce$, while the second green phosphor is a luminescent material according to the general formula $SrSi_2O_2N_2:Eu$. The green phosphors are mixed as powders, individually, with a red phosphor powder in a ratio of 1 : 2 by weight. 16.2 % vol.-% of the mixed phosphor powders were added to a silicone. The spectra were measured using a layer with a thickness of the silicon -phosphor-mixture of about 25 $\mu$m. As one can see in the spectra, the resulting phosphor mixtures have a $\lambda p$ > 600nm.

The particular combinations of elements and features in the above detailed embodiments are exemplary only; Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. Light emitting device, comprising a blue emitting LED, a first phosphor layer exited at the emitting wavelength of the LED, which phosphor has an emission wavelength within a range of between 500 nm and 560 nm, and a second phosphor layer having a color point u' in the range between 0.24 and 0.35 and a peak emission of the phosphor layer of $\lambda p$ > 600nm of the emission spectra, wherein the color point u' is based on the UCS CIE 1976 chromaticity diagram, **characterized in that** the second phosphor layer comprises a material according to the general formula

$$M_{1-x-y-z}Si_{1+z}Al_{1-z}N_{3-z}O_z:Eu^{2+}{}_xCe^{2+}{}_y,$$

   whereby
   M is selected from the group consisting of Ca, Sr or mixtures thereof; and whereby $0.0001 \le x \le 0.005$; $0.001 \le y \le 0.05$ and $0.05 \le z \le 0.25$.

2. The light emitting device of claim 1, whereby y is $\ge 0.005$ and $\le 0.04$.

3. The light emitting device of any of the claims 1 to 2, whereby the content of Ca in M is $\ge 80\%$ (mol/mol).

4. The light emitting device of any of the claims 1 to 2, whereby the content of Sr in M is $\ge 80\%$ (mol/mol).

5. The light emitting device according claim 1 or 4, wherein the blue emitting LED has a peak emission wavelength within the range of between 400 nm and 480 nm.

6. The light emitting device of claim 1 with at least one phosphor layer being a ceramic body having a thickness D of

$80\mu m < D < 300\ \mu m.$

7. A system comprising a light emitting device according to any of the claims 1 to 6, the system being used in one or more of the following applications:

office lighting systems
household application systems
shop lighting systems,
home lighting systems,
accent lighting systems,
spot lighting systems,
theater lighting systems,
fiber-optics application systems,
projection systems,
self-lit display systems,
pixelated display systems,
segmented display systems,
warning sign systems,
medical lighting application systems,
indicator sign systems, and
decorative lighting systems portable systems
automotive applications
green house lighting systems

**Patentansprüche**

1. Licht emittierendes Bauelement, umfassend eine Blau emittierende LED, eine an der emittierenden Wellenlänge der LED angeregte erste Leuchtstoffschicht, wobei der Leuchtstoff eine Emissionswellenlänge innerhalb eines Bereichs zwischen 500 nm und 560 nm aufweist, sowie eine zweite Leuchtstoffschicht mit einem Farbpunkt u' in dem Bereich zwischen 0,24 und 0,35 und einer Spitzenemission der Leuchtstoffschicht von λp > 600 nm der Emissionsspektren, wobei der Farbpunkt u' auf dem UCS CIE 1976 Chromatizitätsdiagramm basiert, **dadurch gekennzeichnet, dass** die zweite Leuchtstoffschicht ein Material gemäß der allgemeinen Formel

$$M_{1-x-y-z}Si_{1+z}Al_{1-z}N_{3-z}O_z:Eu^{2+}{}_xCe^{2+}{}_y$$

umfasst, wobei
M aus der Gruppe, bestehend aus Ca, Sr oder Gemischen daraus, ausgewählt wird, und wobei $0,0001 \leq x \leq 0,005$; $0,001 \leq y \leq 0,05$ und $0,05 \leq z \leq 0,25$.

2. Licht emittierendes Bauelement nach Anspruch 1, wobei $y \geq 0,005$ und $\leq 0,04$ ist.

3. Licht emittierendes Bauelement nach einem der Ansprüche 1 bis 2, wobei der Gehalt an Ca in M $\geq 80\%$ (mol/mol) ist.

4. Licht emittierendes Bauelement nach einem der Ansprüche 1 bis 2, wobei der Gehalt an Sr in M $\geq 80\%$ (mol/mol) ist.

5. Licht emittierendes Bauelement nach Anspruch 1 oder 4, wobei die Blau emittierende LED eine Spitzenemissionswellenlänge innerhalb des Bereichs zwischen 400 nm und 480 nm aufweist.

6. Licht emittierendes Bauelement nach 1, wobei mindestens eine Leuchtstoffschicht ein Keramikkörper mit einer Dicke D von $80\ \mu m < D < 300\ \mu m$ ist.

7. System mit einem Licht emittierenden Bauelement nach einem der Ansprüche 1 bis 6, wobei das System für eine oder mehrere der folgenden Anwendungen eingesetzt wird:

Bürobeleuchtungssysteme
Systeme zur Verwendung im Haushalt
Ladenbeleuchtungssysteme

Wohnraumbeleuchtungssysteme
Akzentbeleuchtungssysteme
Spotbeleuchtungssysteme
Theaterbeleuchtungssysteme
Systeme für Glasfaseranwendungen
Proj ektionssysteme
selbstleuchtende Anzeigesysteme
pixelierte Anzeigesysteme
segmentierte Anzeigesysteme
Warnzeichensysteme
Beleuchtungssysteme zur Verwendung im Medizinbereich
Systeme für Hinweisschilder sowie
Systeme für dekorative Beleuchtung
portable Systeme
Anwendungen im Fahrzeug
Treibhausbeleuchtungssysteme

**Revendications**

1. Dispositif luminescent, comprenant une LED émettant de la lumière bleue, une première couche de phosphore dont la sortie se fait à la longueur d'onde d'émission de la LED, lequel phosphore possède une longueur d'onde d'émission au sein d'une plage d'entre 500 nm et 560 nm, et une seconde couche de phosphore possédant un point de couleur u' dans la plage entre 0,24 et 0,35 et une émission maximale de la couche de phosphore de λp > 600 nm des spectres d'émission, dans lequel le point de couleur u' est fondé sur le diagramme de chromaticité UCS CIE 1976, **caractérisé en ce que** la seconde couche de phosphore comprend un matériau selon la formule générale :

$$M_{1-x-y-z}Si_{1+z}Al_{1-z}N_{3-z}O_z :Eu^{2+}{}_xCe^{2+}{}_y$$

dans lequel
M est sélectionné parmi le groupe constitué de Ca, Sr ou des mélanges de ceux-ci ; et dans lequel $0,0001 \leq x \leq 0,005$ ; $0,001 \leq y \leq 0,05$ et $0,05 \leq z \leq 0,25$.

2. Dispositif luminescent selon la revendication 1, dans lequel y est $\geq 0,005$ et $\leq 0,04$.

3. Dispositif luminescent selon l'une quelconque des revendications 1 à 2, dans lequel la teneur en Ca dans M est $\geq$ 80% (mol/mol).

4. Dispositif luminescent selon l'une quelconque des revendications 1 à 2, dans lequel la teneur en Sr dans M est $\geq$ 80% (mol/mol).

5. Dispositif luminescent selon la revendication 1 ou 4, dans lequel la LED émettant de la lumière bleue possède une longueur d'onde d'émission maximale au sein de la plage entre 400 nm et 480 nm.

6. Dispositif luminescent selon la revendication 1, au moins une couche de phosphore étant un corps en céramique possédant une épaisseur D de 80 $\mu$m < D < 300 $\mu$m.

7. Système comprenant un dispositif luminescent selon l'une quelconque des revendications 1 à 6, le système étant utilisé dans une ou plusieurs des applications suivantes :

systèmes d'éclairage pour bureaux,
systèmes d'application pour foyers,
systèmes d'éclairage pour magasins,
systèmes d'éclairage pour foyers,
systèmes d'éclairage accentué,
systèmes d'éclairage à faisceau étroit,
systèmes d'éclairage pour théâtres,
systèmes d'application à fibres optiques,

systèmes de projection,
systèmes d'affichage auto-éclairés,
systèmes d'affichage pixélisés,
systèmes d'affichage segmentés,
systèmes à signal avertisseur,
systèmes d'application d'éclairage médical,
systèmes à signal indicateur, et
systèmes d'éclairage décoratif,
systèmes portatifs,
applications pour automobiles,
systèmes d'éclairage pour serres.

UCS CIE 1976

FIG. 1

UCS CIE 1976

FIG. 2

FIG. 3

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2007052200 A1
- WO 20080116467 A1
- WO 03080763 A1
- WO 2008007232 A3
- US 20060255710 A1

### Non-patent literature cited in the description

- *Journal of Materials Science,* 2009, vol. 44, 4763-4775